# EUROPEAN PATENT SPECIFICATION

(11) **EP 3 579 404 B1**
(45) Date of publication and mention of the grant of the patent: **24.11.2021**
(21) Application number: 17895150.5
(22) Date of filing: 03.02.2017
(51) Int. Cl.: H02P 29/024

(54) **MOTOR DIAGNOSIS DEVICE**
MOTORDIAGNOSEVORRICHTUNG
DISPOSITIF DE DIAGNOSTIC DE MOTEUR

(43) Date of publication of application: 11.12.2019
(73) Proprietor: Mitsubishi Electric Corporation, Chiyoda-ku Tokyo 100-8310 (JP)
(72) Inventor: MIYAUCHI Toshihiko, Tokyo 100-8310 (JP)
(74) Representative: Witte, Weller & Partner Patentanwälte mbB
(86) International application number: PCT/JP2017/003943
(87) International publication number: WO 2018/142569

(56) References cited:
- WO-A1-2016/151708
- JP-A- 2016 195 524
- JP-A- 2016 195 524
- JP-B1- 5 985 099
- US-A1- 2016 033 580

## Description

### TECHNICAL FIELD

The present invention relates to an electric motor diagnosis device for use in a control center such as an enclosed switchboard or the like, for diagnosing the presence or absence of abnormality of an induction motor.

### BACKGROUND ART

Conventionally, an abnormality diagnosis method of a facility is proposed in which a load current of an induction motor is measured, and its frequency analysis is performed; and, by paying attention to sidebands appearing on both sides of an operating frequency, abnormality of the induction motor and an apparatus driven by means of the induction motor is diagnosed, based on the states of disturbances of an waveform lasting for a short period of time in upward and downward directions, and on undulations being an oscillation of an waveform lasting for a long period of time in upward and downward directions (for example, Patent Document 1).

Patent Document 2, according to its abstract, states that a diagnostic equipment has a current detection unit that detects a current on an electric motor and inputs the same to a current input unit. A logic arithmetic unit analyzes the frequency of current wave form when the current is stable and performs a series of averaging processing on a power spectrum analysis result which is obtained by performing averaging processing plural times. By detecting the sideband wave from the power spectrum analysis result after the averaging processing, the presence or absence of abnormality on the electric motor 5 is determined. When any abnormality is determined, an alarm is output from an alarm output unit.

### RELATED ART DOCUMENT

### [Patent Document]

[Patent Document 1] Japanese Laid-Open Patent Publication No. 2010-288352
[Patent Document 2] JP 2016 195524 A

### SUMMARY OF THE INVENTION

### [Problems to be Solved by the Invention]

In a conventional abnormality diagnosis method of a facility, there arises a problem in that, when load torque variations of an induction motor occur, spectrum intensity increases on both sides in vicinity to a power source frequency (operating frequency), and then the spectrum's intensity becomes larger than oscillation intensity of sideband frequencies appearing in peak states on both sides of the power source frequency, so that it is difficult to detect the sideband frequencies.

The present invention has been directed at solving those problems described above, and an object of the invention is to provide an electric motor diagnosis device capable of diagnosing the presence or absence of abnormality of an electric motor by means of detecting sideband frequencies appearing in peak states on both sides in vicinity to a power source frequency, even in the electric motor whose load torque varies.

### [Means for Solving the Problems]

There is provided an electric motor diagnosis device, comprising: an electric current input unit configured to detect and input therein an electric current of an electric motor; an electric current variation calculation unit configured to acquire the presence or absence of deviation or variation of an electric current inputted from the electric current input unit; an FFT analysis unit configured to analyze a power spectrum of the electric current from the electric current input unit, when the electric current therefrom is in a stable state; a peak detection calculation unit configured to detect a peak position in a power spectrum acquired by the FFT analysis unit; an averaging calculation unit configured to smooth a plurality of charges of power spectra analyzed by the FFT analysis unit; a sideband frequency extraction unit configured to extract a sideband frequency of a power spectrum smoothed by the averaging calculation unit; a rotational frequency band determination unit configured to calculate, based on a sideband frequency extracted by the sideband frequency extraction unit, a difference value between a peak of power spectrum of a power source frequency of the electric motor, and a peak of power spectrum in a rotational frequency band thereof which changes by increase of mechanical vibration due to bearing degradation of the electric motor; and a warning output unit configured to output a warning when a difference value obtained by the rotational frequency band determination unit is a value smaller than a preset value defined in advance.

### [Effects of the Invention]

According to the present invention, it is so arranged that the rotational frequency band determination unit is provided for calculating a difference value between a peak of power spectrum of a power source frequency of an electric motor and a peak of power spectrum in a rotational frequency band thereof, and that, based on the difference value, abnormality of the electric motor is detected, so that it is possible to obtain an electric motor diagnosis device capable of diagnosing the presence or absence of abnormality of an electric motor by means of detecting sideband frequencies appearing in peak states on both sides in vicinity to a power source frequency, even in the electric motor whose load torque varies. In particular, by measuring an electric current of an electric motor, it is achievable to diagnose bearing degradation of the electric motor.

### BRIEF DESCRIPTION OF DRAWINGS

FIG. 1 is a schematic configuration diagram illustrating an installation situation of an electric motor diagnosis device according to Embodiment 1 of the present invention;
FIG. 2 is a block diagram illustrating a configuration of a logic calculation unit of the electric motor diagnosis device according to Embodiment 1 of the present invention;
FIG. 3 is an illustrative diagram for explaining the transformation of frequency axes of the electric motor diagnosis device according to Embodiment 1 of the present invention;
FIG. 4 is an illustrative diagram for explaining peaks of electric current's power spectrum at the time of load degradation of the electric motor diagnosis device according to Embodiment 1 of the present invention; and
FIG. 5 is a flow chart for explaining the operations of the electric motor diagnosis device according to Embodiment 1 of the present invention.

### EMBODIMENTS FOR CARRYING OUT THE INVENTION

Hereinafter, the explanation will be made referring to the drawings for the embodiments according to the present invention. Note that, in each of the figures, the same reference numerals and symbols designate the same items as, or the items corresponding to, those shown in the drawings.

### Embodiment 1.

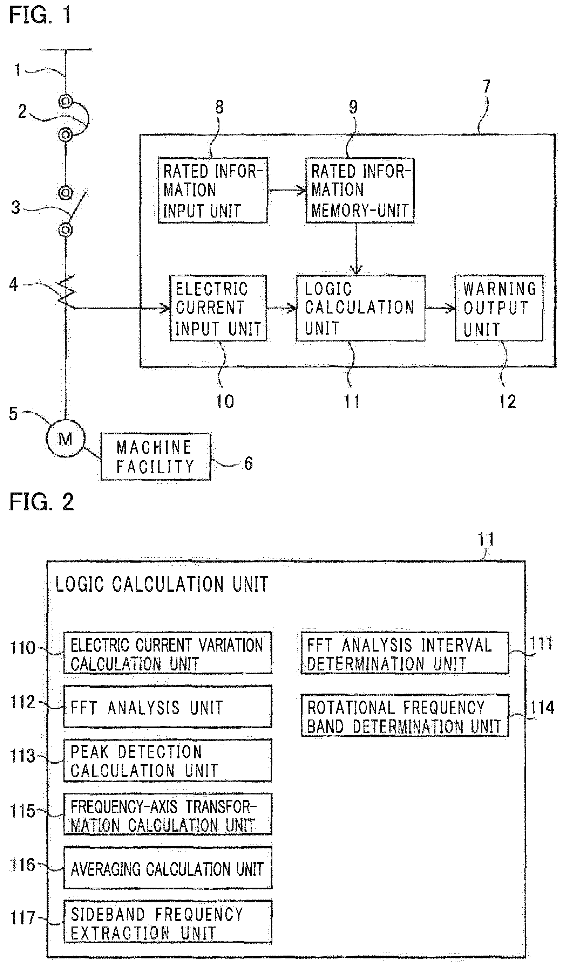

FIG. 1 is a circuit diagram configured to illustrate an electric motor diagnosis device according to Embodiment 1 of the present invention; the device is mainly used in a control center which is an enclosed-switchboard or cubicle. In the figure, for a main circuit 1 which is led in from an electric power system, provided are a molded-case circuit-breaker 2, an electromagnetic contactor 3, and an electric current detector 4 for detecting a load current through the main circuit 1. To the main circuit 1, an electric motor 5 is connected which is a load such as a three-phase induction motor or the like, and a machine facility 6 is operationally driven by means of the electric motor 5. For an electric motor diagnosis device 7, provided are a rated information input unit 8 into which a power source frequency of the electric motor and an electric motor's nominal or rated output, a rated voltage, a rated current, the number of poles, the number of rated revolutions and so forth are inputted in advance, and a rated information memory-unit 9 for maintaining rated information inputted from the rated information input unit 8. The rated information is information which can be easily acquired by having a look at a manufacturing company's catalog of the electric motor 5, or at its plate attached on the electric motor 5. Note that, when there exists a plurality of such electric motors 5 as diagnosis targets under consideration, rated information of the electric motors 5 as diagnosis targets under consideration is inputted in advance; however, in the following description, the explanation will be made for the single electric motor 5. In addition, provided also for the electric motor diagnosis device 7 are an electric current input unit 10 for inputting an electric current detected by the electric current detector 4; a logic calculation unit 11 for detecting, by using an electric current inputted from the electric current input unit 10, the presence or absence of abnormality of a load such as the electric motor 5 and the machine facility 6, and the like; and a warning output unit 12 for outputting a warning by means of an alert or lighting of an abnormality lamp, when abnormality is discovered by the logic calculation unit 11.

The explanation will be made referring to FIG. 2 for a configuration of the logic calculation unit 11. The logic calculation unit 11 is constituted of an electric current variation calculation unit 110 for acquiring the presence or absence of deviation or variation of an electric current inputted from the electric current input unit 10; an FFT (Fast Fourier Transform) analysis interval determination unit 111 for extracting, by using a result having been acquired by the electric current variation calculation unit 110, a section or an interval in which an electric current (s) is stable, and for determining a power spectrum analysis interval; an FFT analysis unit 112 for performing power spectrum analysis by using an electric current of the interval having been determined by the FFT analysis interval determination unit 111; a peak detection calculation unit 113 for detecting a peak position (s) included in a power spectrum having been analyzed by the FFT analysis unit 112; a rotational frequency band determination unit 114 for acquiring, from the peak position(s) having been detected by the peak detection calculation unit 113, a peak position(s) originated as a cause in a rotational frequency (s) of the electric motor; a frequency-axis transformation calculation unit 115 for making frequencies in rotational frequency bands of a plurality of charges of power spectra coincident with each other; an averaging calculation unit 116 for carrying out an averaging or smoothing process on a plurality of charges of power spectra whose frequency axes have been transformed by the frequency-axis transformation calculation unit 115; and a sideband frequency extraction unit 117 extracts, by using a power spectrum having been smoothed by the averaging calculation unit 116, a peak position (s) whether it exists or not on both sides of a power source frequency (hereinafter, the peak position is referred to as a "sideband frequency") other than that existing in a rotational frequency band(s) of the electric motor.

The electric current variation calculation unit 110 calculates stochastic variation or variance of electric current values based on an electric current from the electric current input unit 10. As for the calculation of variance, there exist techniques of, for example, a standard deviation, the Mahalanobis' distance and so forth.

The FFT analysis interval determination unit 111 extracts, from stochastic variation or variance of electric current values having been acquired by the electric current variation calculation unit 110, only an electric current's interval (s) in which variance is in a threshold value or less and the electric current values are in a stable state, and then determines a power spectrum analysis interval. In general, when load torque of the electric motor 5 varies, variance is caused in electric current values; and so, when power spectrum analysis is performed on an electric current waveform whose variance is large, signal intensity on both sides in vicinity to a power source frequency results in increasing, so that a peak position (s) of a sideband frequency and the like ceases appearing. That is to say, it is increasingly performed that a peak position (s) of a sideband frequency or frequencies is included within a signal intensity distribution on both sides in vicinity to the power source frequency, so that it is no more possible to detect a peak position (s) of the sideband frequency or frequencies. In order to prevent this occurring, a threshold value of the FFT analysis interval determination unit 111 is provided therefor.

The FFT analysis unit 112 calculates electric current's power spectrum intensity by performing frequency analysis using an electric current waveform inputted in an interval having been determined by the FFT analysis interval determination unit 111. By carrying out power spectrum analysis using an electric current waveform in which electric current values are in a stable state, there arises no case in which power spectrum intensity increases on both sides in vicinity to a power source frequency, so that, whenever there exists a peakposition(s), it can reliably appear.

The peak detection calculation unit 113 detects, from an analytical result of the electric current's power spectrum intensity, a peak position associated with a power source frequency, peak positions associated with a rotational frequency of the electric motor, peak positions associated with sideband frequencies, and other peak positions . As for detection of peak positions, the detection is made possible by extracting portions from a result calculated by differential calculations of a first-order, a second-order and a third-order where steep gradients reverse at those portions. By performing the differential calculations up to the third-order, it becomes possible to achieve the detection of a peak position of still smaller signal intensity. A peak position associated with a power source frequency can be easily verified because it appears at a place of the power source frequency (in general, 50 Hz or 60 Hz) maintained in the rated information memory-unit 9.

The rotational frequency band determination unit 114 acquires a rotational frequency of the electric motor from the number of rated revolutions maintained in the rated information memory-unit 9, and extracts peak positions existing at places, each being displaced by the quantity of the rotational frequency and having similar signal intensity, in the neighborhood on both sides centering on the power source frequency. In general, a slip is caused in the electric motor 5 in response to the conditions of its load torque, so that displacement is caused in the number of revolutions; and thus, a peak position (s) originated as a cause in a rotational frequency (s) of the electric motor 5 also appears being displaced by the quantity. The rotational frequency band determination unit 114 is a unit which extracts a peak position existing in a frequency band taking the displacement into consideration, and determines the peak position as a rotational frequency band.

Moreover, in order to detect the increase of a rotational frequency component in association with the increase of mechanical vibration in particular due to bearing degradation of the electric motor 5, the rotational frequency band determination unit 114 calculates a difference value between a power spectrum's peak of a power source frequency and a power spectrum's peak in a rotational frequency band, whereby it becomes possible to calculate a power spectrum in the rotational frequency band without being influenced by floor noise existing in the field.

As a result of electric current measurement carried out on various types of electric motors operating in actual factories, it has been obtained as the data that the difference value has a correlation with the degree of degradation of the electric motors.

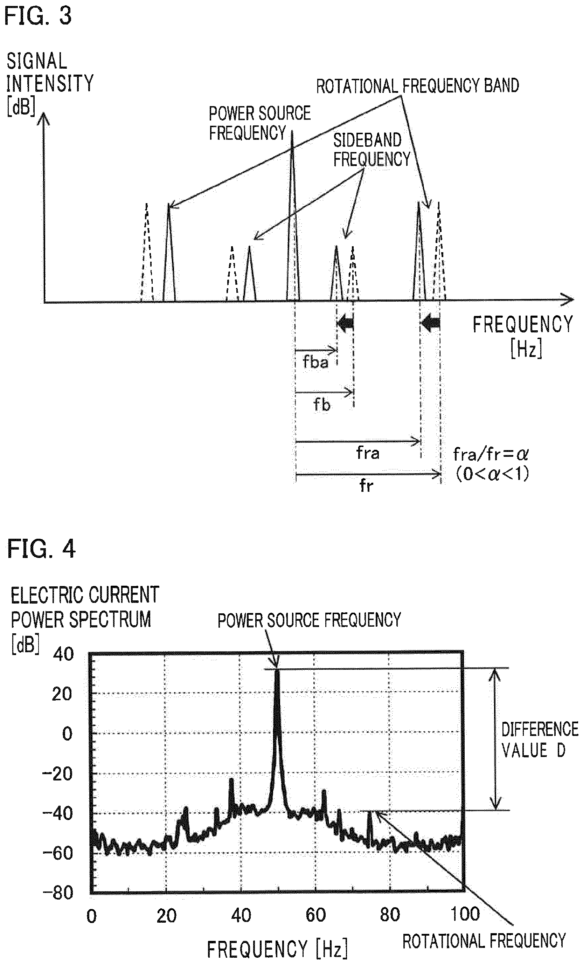

The frequency-axis transformation calculation unit 115 is required to accurately perform the smoothing calculation that is carried out by the averaging calculation unit 116. In general, an appearing place of a sideband frequency which appears due to abnormality of the electric motor 5 has a close relationship to a rotational frequency band, and there frequently arises a case in which a frequency band of the sideband frequency is a multiple of the rotational frequency band. In addition, rotational frequency bands appear being displaced in response to the conditions of load torque of the electric motor 5 as in the explanation described above. For this reason, it is required that a plurality of charges of analytical results of power spectra being smoothing targets is made coincident with each other on their frequency axes by means of a peak position follow-up scheme. To be specific, as shown in FIG. 3, given that a frequency in a rotational frequency band is at a distant place from a power source frequency by "fr," and a frequency of a sideband is at a distant place from the power source frequency by "fb," and that a frequency in a rotational frequency band in which the electric motor 5 is in its no-load state is at a distant place from the power source frequency by "fra, " a transformation factor **"α"** is given by **α** = fra/fr, so that a place of a sideband frequency at the time of no-load, "fba," can be derived by fba = **α·fb.** Note that, the broken-line portions shown in FIG. 3 indicate a signal intensity distribution at a time when there exists a load, and the solid-line portions indicate a signal intensity distribution at the time of no-load. According to the above, by regarding a rotational frequency band as a reference and by multiplying by the transformation factor **"α,"** transformation of frequency axes is performed for all of the peak positions. It should be noted that, in the description stated above, the explanation is made in a case in which a frequency axis is made coincident with that at the time of no-load; however, for example, a frequency axis is made coincident with that at the time of a rated load, and so forth. The frequency-axis transformation calculation unit 115 may be configured so that frequency axes of a plurality of charges of analytical results of power spectra being smoothing targets are made coincident with those at the time of a predetermined load.

The averaging calculation unit 116 is a unit in which an averaging or smoothing process is carried out on a plurality of charges of analytical results of power spectra whose frequency axes are made coincident with each other by the frequency-axis transformation calculation unit 115; and so, by carrying out the smoothing process, base or ground noise is lowered, so that it is made possible to enhance an S/N ratio of the peak position. To be specific, when the smoothing process is carried out on ten charges of analytical results of power spectra, a peak position, which only appears on one charge due to noise or the like, results in being reduced to one tenth of the signal intensity. Meanwhile, when there appear a rotational frequency band and a sideband frequency, peak positions each repeatedly appear for ten times, so that frequencies are made coincident with each other even when frequency axes are transformed by means of a peak follow-up scheme; thus, even after the smoothing being made, signal intensity of the peak positions does not change. Note that, in the description stated above, the explanation is made in a case in which ten charges of analytical results of power spectra are smoothed; however, it is not necessarily limited to the ten charges of them, and so, it suffices to smooth a plurality of charges of them.

The sideband frequency extraction unit 117 extracts, from analytical results of power spectra on which the smoothing process is carried out by the averaging calculation unit 116, peak positions as sideband frequencies which appear centering on the power source frequency at places on both sides each being displaced by the quantity of the same frequency. As for a candidate of a sideband frequency, a peak position having been obtained by the peak detection calculation unit 113 is selected as the candidate. In a case in which, centering on the power source frequency, a peak position appears only on one side, determination is performed that it is not a sideband frequency, so that it is not extracted.

In the rotational frequency band determination unit 114, in order to detect the increase of a rotational frequency component in association with the increase of mechanical vibration in particular due to bearing degradation of the electric motor 5, a difference value D between a power spectrum's peak of a power source frequency and a power spectrum's peak in a rotational frequency band is calculated as in FIG. 4, whereby it becomes possible to calculate a power spectrum in the rotational frequency band without being influenced by floor noise existing in the field.

As a result of electric current measurement carried out on various types of electric motors operating in actual factories, it has been obtained as the data that the difference value D has a correlation with the degree of degradation of the electric motors.

In addition, in the rotational frequency band determination unit 114, determination is performed from the difference value D between a power spectrum's peak of a power source frequency and a power spectrum's peak of a rotational frequency whether the electric motor 5 is abnormal or not. When it is determined that the electric motor 5 is abnormal, a warning is outputted from the warning output unit 12.

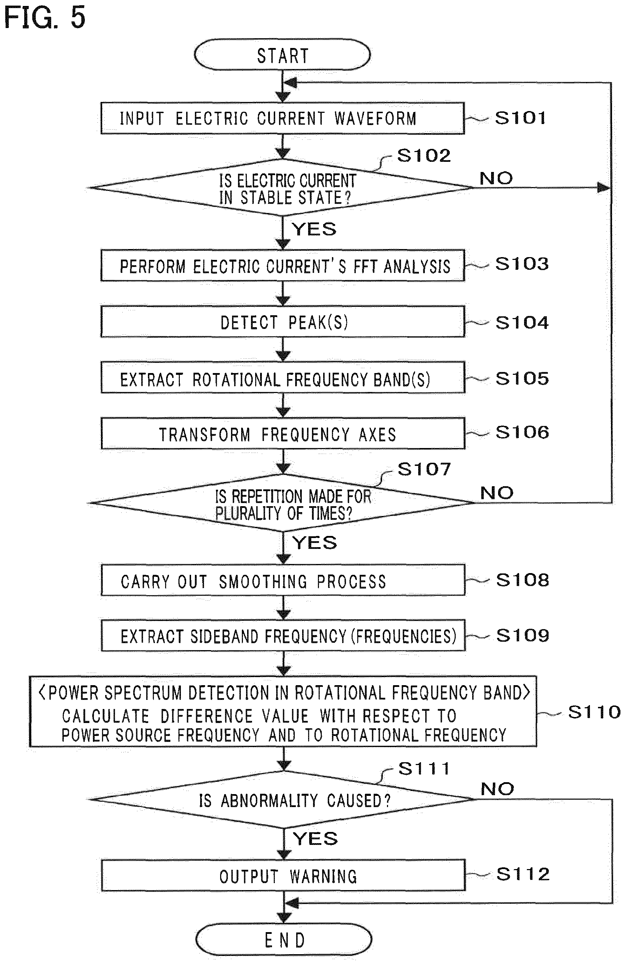

Next, the explanation will be made referring to FIG. 5 for the operations. The electric motor diagnosis device 7 is started up in predetermined time spacings, and the device executes the following processes. At Step S101, an electric current of the electric motor 5 detected by the electric current detector 4 is inputted using the electric current input unit 10. At Step S102, variance of an electric current's root-mean-square value (hereinafter, referred to as an "electric current value") inputted from the electric current input unit 10 is calculated by the electric current variation calculation unit 110, and, by using a calculation result therefrom, determination is performed by the FFT analysis interval determination unit 111 whether an electric current is in a stable state. As a determination result, if variance of electric current values is a threshold value being set in advance or more in an unstable state (NO), the processing is returned to Step S101, and is repeated until the electric current becomes in a stable state. If an electric current is in a stable state (YES), the processing proceeds to Step S103. Note that, in relation to a threshold value, for example, field data of a plurality of motors is preliminarily acquired, and, from an electric current's variation value (a standard deviation) of the data, the selection is made in a range in which variation values are small, so that a value having been selected is defined as the threshold value. As a specific calculation example, variation values are calculated for 50 times, for example, and the variation values are rearranged in increasing order of them: when a first value is 0.5; a second value, 0.6; a third value, 0.65; a fourth value, 0.7; a fifth value, 0.8; a sixth value, 0.85; a seventh value, 1.0; (values from the eighth through the forty-ninth are omitted) ; and a fiftieth value, 3.0, so that the variation value 0.8 being the fifth smallest one among these values is determined as a threshold value. It should be noted that, in place of the preliminary field data, a constant learning time-period is provided in the electric motor 5, and similar calculation may be carried out from an electric current's variation value (a standard deviation) having been acquired during the learning time-period.

At Step S103, the FFT analysis unit 112 performs, by using an electric current waveform in an interval in which electric current values having been inputted are in a stable state, frequency analysis between the frequencies from 0 Hz to a two-fold frequency, 120 Hz, of a power source frequency 60Hz, and hands out an analytical result of power spectrum to the peak detection calculation unit 113. At Step S104, the peak detection calculation unit 113 detects all of peak positions included in the analytical result of power spectrum. At Step S105, the rotational frequency band determination unit 114 extracts a peak position(s) existing in a rotational frequency band(s) among peak positions having been detected, and determines rotational frequency bands. At Step S106, the frequency-axis transformation calculation unit 115 transforms frequency axes of all of the peak positions so that rotational frequency bands having been detected take on rotational frequency bands at the time of no-load. At Step S107, by repeating the operations from Step S101 to Step S106 for ten times, ten analytical results of power spectra whose frequency axes have been transformed are gathered.

At Step S108, the averaging calculation unit 116 carries out the smoothing process on the ten analytical results of power spectra having been gathered. At Step S109, the sideband frequency extraction unit 117 extracts a sideband frequency or frequencies by paying attention to peak positions in an analytical result of the power spectra on which the smoothing process have been carried out. At Step S110, in order to detect a power spectrum in a rotational frequency band, a difference value is calculated with respect to the power source frequency and to a rotational frequency in the rotational frequency band determination unit 114. Namely, the difference value D in FIG. 4 is obtained. At Step S111, in a case in which a sideband frequency is not extracted by the sideband frequency extraction unit 117, or a case in which, although sideband frequencies are extracted, a difference value D having been calculated by the rotational frequency band determination unit 114 is a value larger than a value defined in advance (a preset value), it is determined that abnormality is not caused in the electric motor 5 (NO), so that the diagnosis processing is ended. Meanwhile, when the degree of degradation of abnormality of the electric motor 5 is in progress, attention is paid to that the difference value D becomes smaller: thus, in a case in which a difference value D with respect to a rotational frequency band and to the power source frequency regarding sideband frequencies extracted by the sideband frequency extraction unit 117 is a value smaller than a value defined in advance (a preset value) (YES), it is determined that abnormality is caused in the electric motor 5, so that a signal is sent to the warning output unit 12; and then, at Step S112, a warning is outputted from the warning output unit 12, and the diagnosis processing is ended. Note that, the aforementioned preset value in the sideband frequency extraction unit 117 can be determined from data or the like of a similar electric motor at the time of its past fault (s) ; the more there are exemplary fault cases, it becomes capable of determining an accurate location of an fault by means of a sideband frequency(s) and an extent of the fault thereby. In addition, by setting a plurality of preset values in steps or stages, it becomes possible to grasp the degree of the fault, so that it is made possible to perform a precise abnormality diagnosis.

As described above, a difference value between a power spectrum's peak of a power source frequency and a power spectrum's peak in a rotational frequency band of an electric motor is calculated, and abnormality is detected, so that abnormality detection can be achieved in good accuracy without receiving the influence of ground-based fluctuations due to floor noises on the power source frequency and rotational frequencies in FIG. 4. In addition, by performing power spectrum analysis on an electric current waveform when its electric current values are stable, peak positions of a sideband frequency and the like reliably appear. Moreover, by carrying out the smoothing process on analytical results of power spectra, noise or the like is lowered, so that a more accurate fault diagnosis can be achieved.

The present invention is not necessarily limited to the embodiments described.

### [Explanation of Numerals and Symbols]

Numeral "1" designates a main circuit; "2," molded-case circuit-breaker; "3," electromagnetic contactor; "4," electric current detector; "5," electric motor; "6," machine facility; "7," electric motor diagnosis device; "8," rated information input unit; "9," rated information memory-unit; "10," electric current input unit; "11," logic calculation unit; "12, " warning output unit; "110," electric current variation calculation unit; "111," FFT analysis interval determination unit; "112," FFT analysis unit; "113," peak detection calculation unit; "114," rotational frequency band determination unit; "115," frequency-axis transformation calculation unit; "116," averaging calculation unit; and "117," sideband frequency extraction unit.

## Claims

1. An electric motor diagnosis device, comprising:
an electric current input unit (10) configured to detect and input therein an electric current of an electric motor (5) ;
an electric current variation calculation unit (110) configured to acquire the presence or absence of deviation or variation of an electric current inputted from the electric current input unit (10);
an FFT analysis unit (112) configured to analyze a power spectrum of the electric current from the electric current input unit (10), when the electric current therefrom is in a stable state;
a peak detection calculation unit (113) configured to detect a peak position in a power spectrum acquired by the FFT analysis unit (112);
an averaging calculation unit (116) configured to smooth a plurality of charges of power spectra analyzed by the FFT analysis unit (112);
a sideband frequency extraction unit (117) configured to extract a sideband frequency of a power spectrum smoothed by the averaging calculation unit (116);
**characterised by**:
a rotational frequency band determination unit (114) configured to calculate, based on a sideband frequency extracted by the sideband frequency extraction unit (117), a difference value (D)
between a peak of power spectrum of a power source frequency of the electric motor (5), and a peak of power spectrum in a rotational frequency band thereof which changes by increase of mechanical vibration due to bearing degradation of the electric motor (5); and
a warning output unit (12) configured to output a warning when the difference value (D) obtained by the rotational frequency band determination unit (114) is a value smaller than a preset value defined in advance.

2. The electric motor diagnosis device as set forth in claim 1, wherein the averaging calculation unit (116) is configured to smooth in a state in which peak positions associated with rotational frequency bands are, by transforming a plurality of charges of power spectrum's frequency axes associated therewith, made coincident with each other.

3. The electric motor diagnosis device as set forth in claim 1, wherein the rotational frequency band determination unit (114) is configured to set a plurality of said preset values.

## Patentansprüche

1. Elektromotordiagnoseeinrichtung, mit:
einer Elektrischer-Strom-Eingabeeinheit (10), die dazu konfiguriert ist, einen elektrischen Strom eines Elektromotors (5) zu detektieren und in sich einzugeben;
einer Elektrischer-Strom-Variationsberechnungseinheit (110), die dazu konfiguriert ist, das Vorhandensein oder Abwesendsein einer Abweichung oder Variation eines elektrischen Stroms zu erlangen, der von der Elektrischer-Strom-Eingabeeinheit (10) eingegeben ist,
einer FFT-Analyseeinheit (112), die dazu konfiguriert ist, ein Leistungsspektrum des elektrischen Stroms von der Elektrischer-Strom-Eingabeeinheit (10) zu analysieren, wenn der elektrische Strom davon in einem stabilen Zustand ist;
einer Spitzendetektionsberechnungseinheit (113), die dazu konfiguriert ist, eine Spitzenposition in einem Leistungsspektrum zu detektieren, das durch die FFT-Analyseeinheit (112) erlangt ist;
einer Durchschnittsberechnungseinheit (116), die dazu konfiguriert ist, eine Mehrzahl von Mengen von Leistungsspektra zu glätten, durch die FFT-Analyseeinheit (112) analysiert sind;
einer Seitenband-Frequenz-Extraktionseinheit (117), die dazu konfiguriert ist, eine Seitenband-Frequenz eines Leistungsspektrums zu extrahieren, die durch die Durchschnittsberechnungseinheit (116) geglättet ist;
**gekennzeichnet durch**:
eine Rotationsfrequenzbandbestimmungseinheit (114), die dazu konfiguriert ist, zu berechnen, basierend auf einer Seitenband-Frequenz, die durch die Seitenband-Frequenz-Extraktionseinheit (117) extrahiert ist, einen Differenzwert (D) zwischen einer Spitze eines Leistungsspektrums einer Leistungsquellenfrequenz des Elektromotors (5) und einer Spitze eines Leistungsspektrums in ein Rotationsfrequenzband davon, das sich durch eine Erhöhung einer mechanischen Vibration von einer Lagerverschlechterung des Elektromotors (5) ändert; und
eine Warnungsausgabeeinheit (12), die dazu konfiguriert ist, eine Warnung auszugeben, wenn der Differenzwert (D), der durch die Rotationsfrequenzbandbestimmungseinheit (114) erlangt ist, ein Wert ist, der kleiner als ein voreingestellter Wert ist, der im Vorherein definiert ist.

2. Elektromotordiagnoseeinrichtung nach Anspruch 1, wobei die Durchschnittsberechnungseinrichtung (116) dazu konfiguriert ist, in einem Zustand zu glätten, in dem die Spitzenpositionen, die mit Rotationsfrequenzbändern verknüpft sind, durch Transformieren einer Mehrzahl von Mengen von Frequenzachsen des Leistungsspektrums, die diesen zugeordnet sind, miteinander zusammenfallend gemacht sind.

3. Elektromotordiagnoseeinrichtung nach Anspruch 1, wobei die Rotationsfrequenzbandbestimmungseinheit (114) dazu konfiguriert ist, eine Mehrzahl der voreingestellten Werte festzusetzen.

## Revendications

1. Dispositif de diagnostic de moteur électrique, comprenant :
une unité d'entrée de courant électrique (10) configurée pour détecter et y entrer un courant électrique d'un moteur électrique (5) ;
une unité de calcul de variation de courant électrique (110) configurée pour acquérir la présence ou l'absence d'un écart ou d'une variation d'un courant électrique entré depuis l'unité d'entrée de courant électrique (10) ;
une unité d'analyse FFT (112) configurée pour analyser un spectre de puissance du courant électrique depuis l'unité d'entrée de courant électrique (10) lorsque le courant électrique qui en provient se trouve dans un état stable ;
une unité de calcul de détection de pic (113) configurée pour détecter une position de pic dans un spectre de puissance acquis par l'unité d'analyse FFT (112) ;
une unité de calcul de moyenne (116) configurée pour lisser une pluralité de charges de spectres de puissance analysés par l'unité d'analyse FFT (112) ;
une unité d'extraction de fréquence de bande latérale (117) configurée pour extraire une fréquence de bande latérale d'un spectre de puissance lissé par l'unité de calcul de moyenne (116) ;
**caractérisé par** :
une unité de détermination de bande de fréquence de rotation (114) configurée pour calculer, sur la base d'une fréquence de bande latérale extraite par l'unité d'extraction de fréquence de bande latérale (117), une valeur de différence (D) entre un pic de spectre de puissance d'une fréquence de source d'alimentation du moteur électrique (5) et un pic de spectre de fréquence dans sa bande de fréquence de rotation qui varie par augmentation d'une vibration mécanique due à une détérioration de palier du moteur électrique (5) ; et
une unité de délivrance d'avertissement (12) configurée pour délivrer un avertissement lorsque la valeur de différence (D) obtenue par l'unité de détermination de bande de fréquence de rotation (114) est une valeur inférieure à une valeur préétablie définie au préalable.

2. Dispositif de diagnostic de moteur électrique selon la revendication 1, dans lequel l'unité de calcul de moyenne (116) est configurée pour lisser dans un état où des positions de pic associées à des bandes de fréquence de rotation sont amenés à coïncider entre elles par transformation d'une pluralité de charges d'axes de fréquence du spectre de puissance qui leur sont associés.

3. Dispositif de diagnostic de moteur électrique selon la revendication 1, dans lequel l'unité de détermination de bande de fréquence de rotation (114) est configurée pour établir une pluralité desdites valeurs préétablies.
